Europäisches Patentamt

European Patent Office

Office européen des brevets

(19)

(11) Publication number: **0 252 714**
**A2**

(12) # EUROPEAN PATENT APPLICATION

(21) Application number: **87305985.1**

(22) Date of filing: **07.07.87**

(51) Int. Cl.4: **G01R 31/28**

(30) Priority: **08.07.86 JP 160261/86**

(43) Date of publication of application:
**13.01.88 Bulletin 88/02**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Mitono, Yoshiharu**
**Tamainagi manshion 1-919 536-5, Oomaru**
**Inagi-shi Tokyo(JP)**

(74) Representative: **Billington, Lawrence Emlyn et al**
**HASELTINE LAKE & CO Hazlitt House 28**
**Southampton Buildings Chancery Lane**
**London WC2A 1AT(GB)**

(54) **Semiconducteur integrated circuit device having a tester circuit.**

(57) A semiconductor integrated circuit device formed in a single chip includes a logic circuit formed by a plurality of combination circuits and a sequence circuit; and an oscillator circuit receiving an external control signal during a test and generating a clock signal having a predetermined repetitive frequency. The device also includes a pulse signal generator circuit receiving the clock signal and producing a plurality of test pulse signals having different timings and producing a strobe signal at a predetermined time period; a gate circuit fetching the plurality of test pulse signal in response to incoming test pattern data from an external source in synchronization with the strobe signal and supplying the test pulse signals to the logic circuit; and a register circuit retaining a plurality of output signals of the logic circuit receiving the test pulse signals and outputting the test pulse signals externally as output data.

Fig. 1

## SEMICONDUCTOR INTEGRATED CIRCUIT DEVICE HAVING A TESTER CIRCUIT

BACKGROUND OF THE INVENTION

l. Field of the Invention

The present invention relates to a semiconductor integrated circuit device having a tester circuit, and more particularly, to a device having further a logic circuit composed of a plurality of combinational circuits and sequential circuits, enabling implementing the dynamic function test.

2. Description of the Related Arts

A semiconductor integrated circuit having a logic circuit arrangement composed of a combinational logic circuit such as an AND circuit, or the like, and a sequential circuit such as flip-flop circuits, is known.

A single integrated circuit chip or device provides a complete microcomputer circuit having, for example, a CPU, a RAM, an EPROM, and input/output ports and the like, and during production, it is necessary to test whether or not the above-noted semiconductor integrated circuit can be operated at a normal state without malfunctioning.

In the prior art, the above-noted semiconductor integrated circuit device is connected to a tester in the course of manufacturing and supplied with test data produced by the tester and thereby a function test is carried out which determines whether or not a desired output data responsive to the test data can be obtained from the semiconductor integrated circuit device.

In general, there are two kinds of function tests, i.e., a static function test and a dynamic function test. In the static function test, test data is supplied to a semiconductor integrated circuit device, the output data is fetched after a lapse of a predetermined time, and it is determined whether or not a logic operation in the semiconductor integrated circuit device can be carried out in the normal manner. In the dynamic function test method, each bit of the test data is supplied to the semiconductor integrated circuit device separately at a different timing and it is determined whether or not the semiconductor integrated circuit can operate normally at a real time operating speed.

A semiconductor integrated circuit is designed, to have the highest circuit operation speed possible. However, a semiconductor integrated circuit is employed in a tester comprising a prior and lower speed integrated circuit by which the above-described function test is implemented, and therefore, there is a limit to the repetitive frequency range of the pulse which can be produced in the tester system. Accordingly, when the operation speed of the semiconductor integrated circuit which has been developed after a tester has been manufactured is faster than the IC in the tester system, the tester circuit can not produce the high frequency clock signal needed for a dynamic function test of the newly developed semiconductor integrated circuit and the upper limit to the amount of test data which distinguishes the timing of each bit can not be raised to the required extent. Therefore, a problem arises in that a dynamic function test substantially can not be carried out.

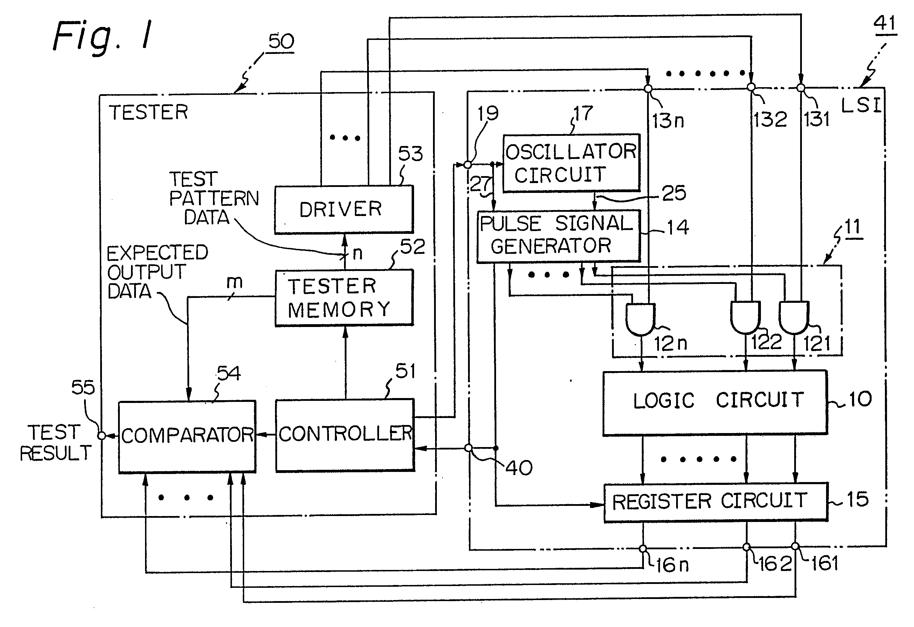

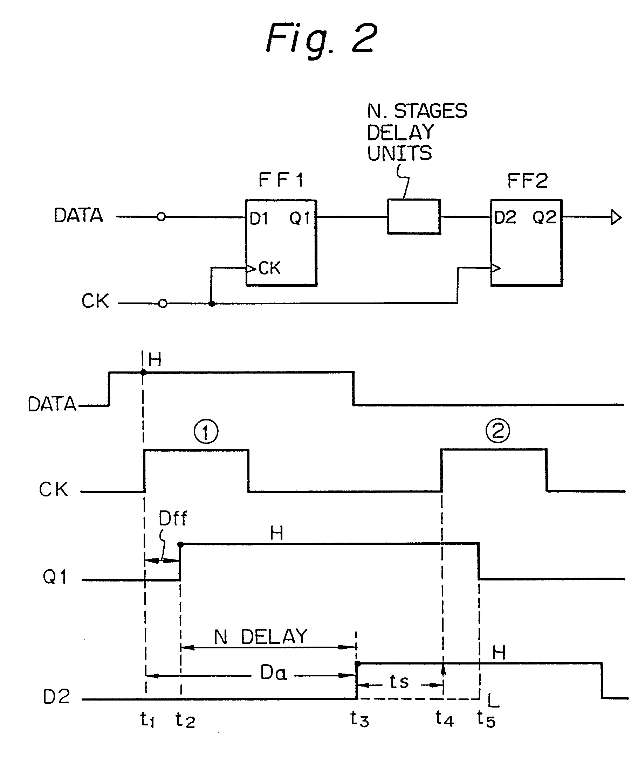

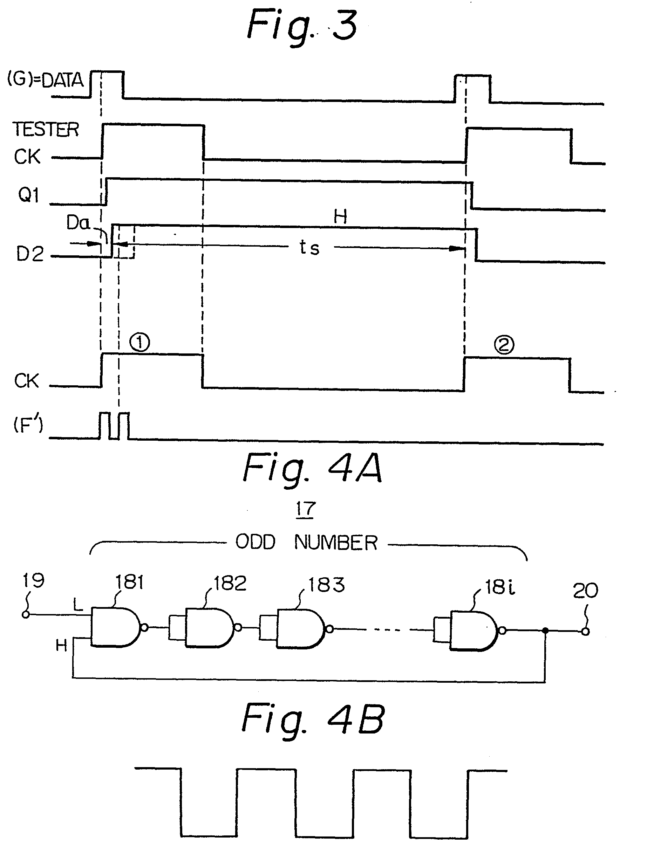

As will be described later in Fig. 2 and 3, there occurs a generation of a delay time between each flip-flops. For example, a shift register of n stages (n = 4) which has, for example, four flip-flops for functioning as a l/2 demultiplier, outputs l/l6 of an amount compared with the amount of an input. In this case, if the set-up time is not so large, the HIGH level signal at some input node may be regarded as an LOW level signal. However, even if such malfunction is tried to be inspected by using the tester system, since the tester system does not have an ability to produce such a high frequency clock signal, such malfunction of the circuit to be developed can not be found so that the tester system may give the result of no malfunction.

Therefore, the prior art semiconductor integration circuit can identify a high speed operation only by a simulation.

The present invention is intended to solve this problem.

SUMMARY OF THE INVENTION

An object of the present invention is to provide a semiconductor integrated circuit by which a dynamic function test can be carried out without malfunctioning.

In accordance with the present invention, there is provided a semiconductor integrated circuit device formed in a single chip including:

a logic circuit formed by a plurality of combination circuits and a sequence circuit;

an oscillator circuit receiving an external control signal during a test and generating a clock signal having a predetermined repetitive frequency;

a pulse signal generator circuit receiving the clock signal and producing a plurality of test pulse signals having different timings and producing a strobe signal at a predetermined time period;

a gate circuit fetching the plurality of test pulse signal in response to incoming test pattern data from an external source in synchronization with the strobe signal and supplying the test pulse signals to the logic circuit; and

a register circuit retaining a plurality of output signals of the logic circuit receiving the test pulse signals and outputting the test pulse signals externally as output data.

In accordance with the present invention, there is also provided a system for testing the operation of a semiconductor integrated circuit device formed in a single chip in assoclation with a tester circuit, the system including:

a logic circuit formed by a plurality of combination circuits and a sequence circuit;

an oscillator circuit receiving an external control signal during a test and generating a clock signal having a predetermined repetitive frequency;

a pulse signal generator circuit receiving the clock signal and producing a plurality of test pulse signals having different timings and producing a strobe signal at a predetermined time period;

a gate circuit fetching the plurality of test pulse signal in response to incoming test pattern data from an external source in synchronization with the strobe signal and supplying the test pulse signals to the logic circuit; and

a register circuit retaining a plurality of output signals of the logic circuit receiving the test pulse signals and outputting the test pulse signals externally as output data.

a tester circuit for testing the normal operation of the semiconductor integrated circuit. A test of the semiconductor integrated circuit is carried out based on a comparison between the output data of the register circuit and a predetermined expected signal output determined by the test pattern data.

In accordance with the present invention, since an oscillator circuit and a pulse signal generator circuit may be constituted by the same kind of bipolar or MOS elements as those of a logic circuit, the repetitive frequency of a clock signal can be made the same as the operation speed of the logic circuit and the timing of a plurality of testing pulse signals can be distinguished therefrom as the real time operation speed of the logic circuit.

## BRIEF DESCRIPTION OF THE DRAWINGS

Figure I is a block diagram of an embodiment of a semiconductor integrated circuit in accordance with the present invention;

Fig. 2 is a waveform diagram of data and clocks in the logic circuit;

Fig. 3 is an enlarged portion of the waveform diagram shown in Fig. 2;

Fig. 4A is a circuit diagram of a ring oscillator;

Fig. 4B is the waveform of the output of the oscillator in Fig. 4A;

Fig. 5 is a schematic diagram of a pulse signal generator circuit;

Fig. 6 is a waveform diagram of signals shown in Fig. 5; and

Fig. 7 is a partial circuit diagram of a logic circuit.

## DESCRIPTION OF THE PREFERRED EMBODIMENTS

Figure I is a block diagram of one embodiment of a semiconductor integrated circuit of the present invention. In Fig. I, reference numeral I0 denotes a logic circuit constituted by a combination of AND circuits and OR circuits or the like and a sequence circuit such as flip-flops and counters or the like. The logic circuit I0 is the subject of the test. 4I denotes a semiconductor integrated circuit chip or device which includes the logic circuit I0 for a normal function and an oscillator circuit I7, a pulse signal generator I4, a gate circuit II and a register circuit I5 so as to make the dynamic function test enable.

Data is supplied to the logic circuit I0 by AND circuits I2I to I2n of a gate circuit II. Data input from terminals I3I to I3n is supplied to the AND circuits I2I to I2n in addition to a test pulse signal supplied to the AND circuits from the pulse signal generator circuit I4, as described later. In the test mode, the AND circuit which receives H level of the data input supplies a test pulse signal to the logic circuit I0 according to the timing of the test pulse signal from the pulse signal generator circuit I4. In the normal operation mode, all pulse signal from the pulse signal generator circuit I4 are H level so that the data inputs from the terminals I3 are supplied to the logic circuit I0 through the AND gate I2.

Data output from the logic circuit I0 is supplied to a register I5 formed by $\underline{m}$ flip-flops, and when a strobe signal is received, the data is held in the flip-flop circuits and then is output from the terminal I6I to I6m. Each flip-flop in the register circuit I5 is a part of the logic circuit I0 during normal operation, and when a test is to be carried out, one of the flip-flops switches the connection over to form a register.

The prior art problems on a dynamic function test will be described with a concrete circuits. The circuit of Fig. 2 includes two flip-flop circuits FFI and FF2, and a delay circuit therebetween.

During a normal operation, as shown in the waveform diagram of Fig. 2, when data is at a HIGH level and a pulse ① of a clock signal CK is input at a time tl, the output Ql rises up to an HIGH level at a time t2 after a delay time Dff of the flip-flop FFl. At a time t3 after the delay time via n stages of delay circuits, the input $D_2$ of a flip-flop FF2 rises to a HIGH level. That is, after a time interval Da since an incoming of a pulse ① of a clock signal CK, the input $D_2$ of a second stage of the flip-flop FF2 is at an HIGH level state. At a time t4 after an interval ts from a time t3, the following pulse ② of the clock signal CK is input and the flip-flop FF2 picks up the HIGH level state of the input $D_2$.

The delay time Dff of the flip-flop FFl is about l50 pico-seconds and with regard to n stages of delay circuit, for example one stage amount is equal to 200 pico-seconds and l0 stages amount is equal to 2 ns. Therefore, the delay time Da is, for example, 2.l5ns. Then, the clock signal CK has a timing of, for example, 3 ns to raise the pulses ① and ② .

In such logic circuit, when the n stages of delay circuit is ill-conditioned and there happens a delay time, higher than the design requirement value, the waveform of raising is delayed at $D_2$ as shown in broken lines. Such being the case, when the input of $D_2$ raises to a HIGH level at a time t5, due to the rise of a pulse ② of a clock signal Ck, the flip-flop FF2 picks up a LOW level. That is, when a set-up time Ts is very short, the above-mentioned exacting timing condition is required.

Figure 3 shows an operational waveform when the circuit shown in Fig. 2 is tested by the conventional tester. A clock signal Ck from a conventional extenal tester is input with, for example, a timing of tens of n Sec. The clock signal of the tester is utilized as an internal clock signal. As the time interval between the pulses ① and ② of the clock signal from the tester is tens of n sec and is much larger than the time interval Da from the first pulse ① to a time when the input D2 of the flip-flop FF2 raises, if the input D2 delays as shown in the broken line in Fig. 3, the delay time can not be detected by the seocnd pulse ② . That is, since the level of the input D2 picked up by the second pulse ② is at a HIGH level in spite of delaying of the input D2 as shown in the broken line, so the tester cannot detect the malfunction of the logic circuit.

Contrary to this, om accordance with the present invention as shwon in Fig. l, there is provided an oscillator circuit l7 which can produce a clock signal for testing use with a short timing and a pulse signal generator circuit l4 in its own chip 4l.

The present invention is so designed that a predetermined input data from the tester 50 is supplied to a logic circuit by its own high speed timing pulse to implement a dynamic function test fully.

Figure 4 is a connection diagram of a ring oscillator circuit l7 shown in the Fig. l. In the figure, the odd number of NAND circuits l8l to l8i form a loop, and if an H potential level control signal is supplied from a terminal l9, oscillation occurs and a clock signal having a predetermined frequency is output from the terminal 20. The clock signal is delivered to a pulse signal generator circuit l4.

The NAND circuits l8l to l8n have the same constitution as a NAND circuit forming the logic circuit l0 and are constituted by the same bipolar or CMOS circuit of the logic circuit l0. The faster the operational speed of the logic circuit l0, the higher the repetitive frequency of a clock signal responsive to the operational speed (delay time) in the NAND circuits l8l to l8n. As a result, the pulse width of the test pulse signal, described later, can be made as small as that at which the dynamic function test can be fully completed.

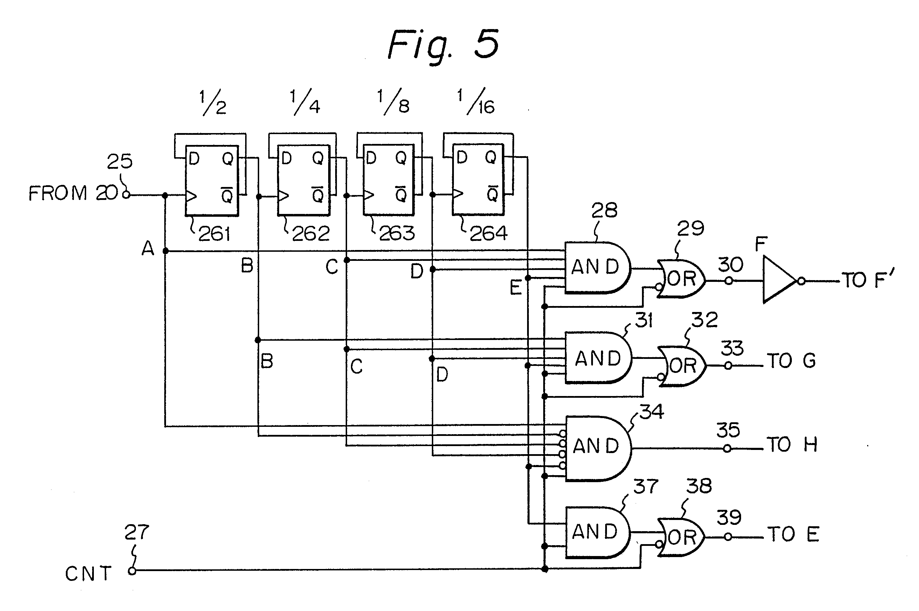

As shown in the Fig. l, a pulse signal generator circuit l4 receives a clock signal from the oscillator circuit l7 and a control signal from the tester 50 through the terminal l9 and produces a test pulse signal and a strobe signal at a predetermined time interval. One example of the pulse signal generator circuit l4 is partially shown in Fig. 5.

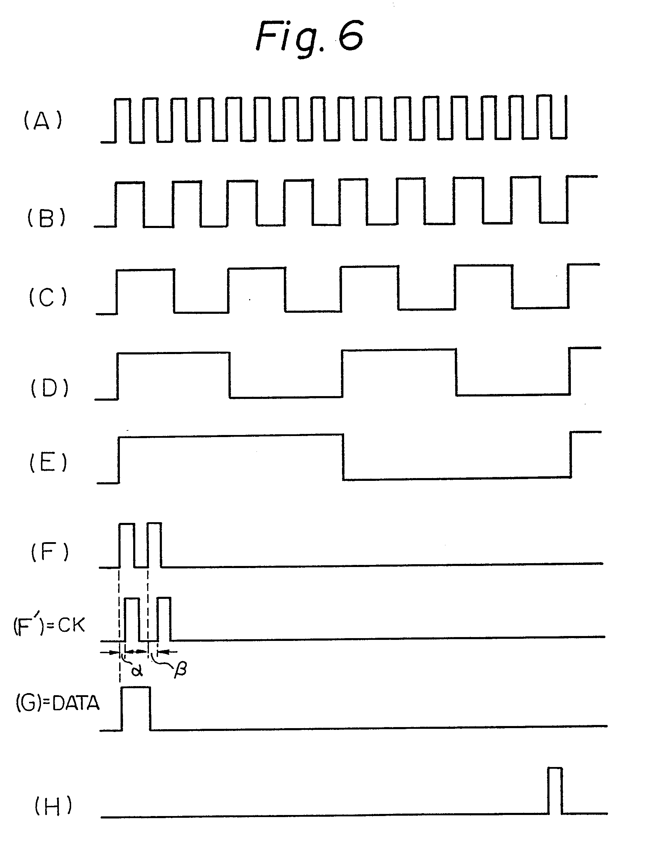

In Fig. 5, the clock signal input to the terminal 25 as shown in Fig. 6A is divided in two, in sequence, by cascade-connected D type flip-flops 26l, 262, 263 and 264, respectively, and each of flip-flops 26l, 262, 263 and 264 produces a signal as shown in Figs. 6B, 6C, 6D and 6E, respectively. In the case of only a test operation, a control signal CNT having an H potential level is input to the terminal 27.

When the control signal CNT is at an H potential level, an AND circuit 28 produces a test pulse signal (Fig. 6F) per sixteen clock cycles from a clock signal A, a control signal CNT, and respective outputs C,D,E of flip-flops 262, 263 and 264, and then outputs an F signal through an OR circuit 29 from a terminal 30 and an F′ signal through inverter logic outputs. An AND circuit 3l produces a test pulse signal from a control signal CNT and respective outputs B.C.D.E. of flip-flops 26l, 262, 263 and 264 per sixteen clock cycles as shown in Fig. 6G, and outputs that signal through an OR circuit 32 from a terminal 33. An AND circuit 34 produces a strobe signal from a clock signal A, a control signal CNT and an inverted output B.C.D.E. of the flip-flops 26l, 262, 263 and 264, respectively, per sixteen clock cycles as shown in Fig. 6H, and outputs the strobe signal from a terminal 35. An AND circuit 37 produces a test pulse signal from a control signal CNT and an output E of a flip-flop 264 per sixteen clock cycles as shown in Fig. 6E, and outputs the test pulse signal from a terminal 39 through an OR circuit 38.

When the control signal CNT is at an L potential level, that is, in a normal operation period, OR circuits 29, 32, 35 and 38 are at an H potential level, respectively.

The test pulse signals as shown in Fig. 6E, 6F, 6F', and 6G are supplied to the AND circuits 121 to 12n of a set of gate circuits 11, and the strobe signal shown in Fig. 6H is supplied to a register circuit 15 and output from a terminal 40. Therefore, in the normal operation period, all test pulse signals, i.e. the outputs of the OR circuit 29, 32, 35, 38 in the pulse signal generator 14, are H level so that the input data from the terminal 131 ~ 13ln are provided to the logic circuit 10 through the gate 11.

Next, a description will be given of the effect of the delay circuit in the AND circuits. When the output of an OR circuit 29 is output from a terminal 30, a test pulse signal shown in Fig. 6F can be delayed into the test pulse signal shown in Fig. 6F' by a delay time of the inverter circuit. In this way the timing of a respective test pulse signal can be changed arbitrarily in response to the real time operation of the logic circuit.

The above-described logic circuit 10, gate circuit 11, a pulse signal generator circuit 14, a register circuit 15, and oscillator circuit 17 are formed as a single semiconductor integrated circuit chip 41.

When a test of the above-described semiconductor integrated circuit 41 is carried out, a tester 50 is connected therewith.

A controller 51 of the tester 50 generates a control signal at an H potential level and supplied the signal to an oscillator circuit 17 and a pulse signal generator circuit 14 from the terminal 19, respectively. Therefore, the strobe signal which is produced from the pulse signal generation circuit 14 is supplied to the controller 51 from the terminal 40.

The controller 51 accesses a tester memory 52 in synchronization with the above-described strobe signal and a test pattern data of n bits is read out in order from the tester memory 52. This test pattern data has a separate different bit pattern for each address. The test pattern data is amplified by a driver 53 to a predetermined level and is supplied to the terminals 131 to 13n of the semiconductor integrated circuit 41, respectively. The test pattern data carries out the gating of the AND circuits 121 to 12n in a set of gate circuits 11. Among the AND circuits 121 to 12n, only the AND circuit to which an H potential level signal is supplied in response to the test pattern data fetches a test pulse signal from the pulse signal generator circuit 14 and supplies the signal to the logic circuit 10.

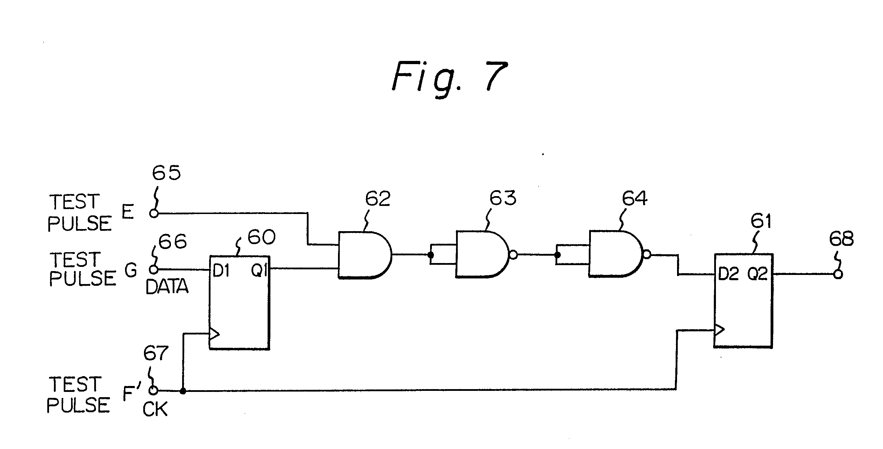

Assuming that a part of the logic circuit 10 is, as shown in Fig. 7 which is substantially the same as Fig. 2, formed by flip-flops 60, 61, an AND circuit 62, and NAND circuits 63, 64 connected therebetween, and further, the delay time of these circuit elements is, for example, 1 n sec, and the period of the clock signal output by the oscillator circuit 17 is 10 n sec.

A test pulse E is input to a terminal 65 from a gate circuit 11 as shown in Fig. 6E by a predetermined test pattern data, a test pulse G is input to a terminal 66 as shown in Fig. 6G, and a test pulse F' is input to a terminal 67 as shown in Fig. 6F'. Therefore, the above test pulse G corresponds to DATA shown in FIG. 3 and the test pulse F' corresponds to the clock signal as shown in Fig. 3.

That is to say, in Fig. 7 which is the same circuit as in Fig. 2, test pulses G and F' produced from a pulse signal generating circuit 14 which is formed by circuit elements within the same IC chip, is input as data to $D_1$ and a clock CK. The timing of these testing pulses G and F' is an exacting and especially the test pulse F' is a fast clock signal as shown in Fig. 2. Therefore, as shown in Fig. 3, the test pulse F' can detect the malfunction accompanied by an undesired delay in the delay circuits 62, 63 and 64.

When the circuit of Fig. 7 operates with a normal delay, the output 68 of a flip-flop 61 is at a HIGH potential level. Contrary to this, when the circuit of Fig. 7 operates with an extraordinary delay, the output 68 of the flip-flop 61 is at a LOW potential level. In this way, it is determined whether or not the circuit shown in Fig. 5 can carry out a fast operation as required, and the same dynamic function test as for the real time operation in the logic circuit 10 is carried out.

The signal output by the logic circuit 10 is latched when the strobe signal is received at a register circuit 15, and then supplied to a comparator 54 of the tester 50 from terminals 161 to 16m as output data, and the output data is then compared per bit with the expected value data read from the tester memory 52. The expected value data responds to a test pattern data. The controller 51 supplies the output control signal produced in synchronization with the strobe signal to the comparator 54 and after the output control signal is received, the comparator 54 outputs test result data from a terminal 55, which is an exclusive OR operational result between, for example, an output data and the expected value data. As a result, every time the bit pattern of the test pattern data is changed, test result data is output from a terminal 55 to implement a dynamic function test of each part in the logic circuit 10.

## Claims

1. A semiconductor integrated circuit device formed in a single chip comprising:

a logic circuit formed by a plurality of combination circuits and sequence circuits;

an oscillator circuit receiving an external control signal during a test and generating a clock signal having a predetermined repetitive frequency;

a pulse signal generator circuit receiving said clock signal and producing a plurality of test pulse signals having different timings and producing a strobe signal at a predetermined time period;

a gate circuit fetching said plurality of test pulse signal in response to incoming test pattern data from an external source in synchronization with said strobe signal and supplying said test pulse signals to said logic circuit; and

a register circuit retaining a plurality of output signals of said logic circuit receiving said test pulse signals and outputting said test pulse signals externally as output data.

2. A semiconductor integrated circuit device according to claim 1, wherein said test result data is output in response to a difference of bit pattern in said test pattern data, to implement a dynamic function test of each part of said logic circuit.

3. A system for testing the operation of a semiconductor integrated circuit device formed in a single chip in association with a tester circuit, said system comprising:

a logic circuit formed by a plurality of combined circuits and sequence circuits;

an oscillator circuit receiving an external control signal during a test and generating a clock signal having a predetermined repetitive frequency;

a pulse signal generator circuit receiving said clock signal and producing a plurality of test pulse signals having different timings and producing a strobe signal at a predetermined time period;

a gate circuit fetching said plurality of test pulse signal in response to incoming test pattern data from an external source in synchronization with said strobe signal and supplying said test pulse signals to said logic circuit;

a register circuit retaining a plurality of output signals of said logic circuit receiving said test pulse signals and outputting said test pulse signals externally as output data; and

a tester circuit for testing the normal operation of said semiconductor integrated circuit;

a test of said semiconductor integrated circuit being carried out based on a comparison between the output data of said register circuit and a predetermined expected signal output determined by said test pattern data.

# Fig. 1

TESTER 50

TEST PATTERN DATA

EXPECTED OUTPUT DATA

DRIVER 53

TESTER MEMORY 52

COMPARATOR 54

CONTROLLER 51

TEST RESULT 55

OSCILLATOR CIRCUIT 17

19

27

25

PULSE SIGNAL GENERATOR 14

13n  132  131  LSI 41

11

12n  122  121

LOGIC CIRCUIT 10

40

REGISTER CIRCUIT 15

16n  162  161

0 252 714

# Fig. 2

## Fig. 3

## Fig. 4A

17

ODD NUMBER

## Fig. 4B

# Fig. 5

FROM 20 —o 25

1/2  1/4  1/8  1/16

261  262  263  264

28 AND — 29 OR — 30 —o F — TO F'

31 AND — 32 OR — 33 —o TO G

34 AND — 35 —o TO H

37 AND — 38 OR — 39 —o TO E

27 CNT —o

0 252 714

# Fig. 6

(A)

(B)

(C)

(D)

(E)

(F)

(F')=CK

α    β

(G)=DATA

(H)

Fig. 7

0 252 714